# EUROPEAN PATENT APPLICATION

(11) **EP 4 660 622 A1**
(43) Date of publication of application: **10.12.2025**
(21) Application number: 24880030.2
(22) Date of filing: 08.10.2024
(51) Int. Cl.: G01N 27/22, G01R 31/385, G01R 31/396, G01R 19/165

(54) **BATTERY MANAGEMENT APPARATUS AND BATTERY MANAGEMENT METHOD**

(30) Priority: 16.10.2023 KR 20230137997
(71) Applicant: LG Energy Solution, Ltd., Seoul 07335 (KR)
(72) Inventor: CHA, A-Ming, Daejeon 34122 (KR); BAE, Yoon-Jung, Daejeon 34122 (KR); KIM, Yong-Jun, Daejeon 34122 (KR)
(74) Representative: Goddar, Heinz J.
(86) International application number: PCT/KR2024/015250
(87) International publication number: WO 2025/084692

(57) **Abstract**

A battery management includes a setting control unit configured to set a reference voltage that is a reference of determination of a risk caused by a rapid increase of gas, a measurement unit configured to measure a voltage of a battery cell, and a diagnosis unit configured to diagnose the battery cell as a dangerous cell in which a degree of risk caused by the rapid increase of gas is equal to or higher than a predetermined level when a state in which the voltage of the battery cell is higher than the reference voltage lasts for a first reference time or more.

## Description

### TECHNICAL FIELD

The present disclosure relates to battery state diagnosis and management, and more particularly, to a battery management apparatus and method for diagnosis a dangerous condition caused by rapid increase of gas in a battery using characteristics of a differential profile.

The present application claims priority to Korean Patent Application No. 10-2023-0137997 filed on October 16, 2023 in the Republic of Korea, the disclosure of which is incorporated herein by reference.

### BACKGROUND ART

Recently, there has been a rapid increase in the demand for portable electronic products using electricity as a power source, such as laptop computers, video cameras and mobile phones, and with the spread use of mobile robots, e-bikes, electric carts and electric vehicles, many studies are being made on high performance secondary batteries that can be repeatedly charged and discharged.

Commercially available secondary batteries include nickel-cadmium batteries, nickel-hydrogen batteries, nickel-zinc batteries, lithium secondary batteries and the like, and among them, lithium secondary batteries have little or no memory effect compared to nickel-based batteries, and thus they are attracting more intensive research and have a wider range of applications than the other types of secondary batteries for their advantages that recharging can be done whenever it is convenient, the self-discharge rate is very low and the energy density and operating voltage is high.

Recently, secondary batteries are widely used in not only small devices such as mobile electronic devices but also medium and large devices such as electric vehicles or Energy Storage Systems (ESS).

As opposed to energy generation methods based on fossil fuel, secondary batteries generate energy by electrochemical reaction. Accordingly, secondary batteries cannot maintain the performance at Beginning of Life (BOL), and are gradually degraded or age as charge/discharge cycles continue or repeat.

As the use (charge/discharge) of batteries continues, usability reduces due to capacity decline or output degradation and safety also acts as a risk factor, and in order to maintain continuity of normal operation, control for limited use, determine when to replace and improve efficiency of battery reuse or recycling, it is necessary to accurately diagnose the current state of batteries.

By the degradation of batteries as well as external factors such as defects in manufacturing process or external impacts, gas may be generated in the batteries.

When gas is generated in batteries, the state of the batteries becomes unstable, causing rapid changes such as impossible to operate or pressure rise accompanied by temperature increase, and consequential critical safety problems of the batteries themselves such as fire or explosion.

Gas detection sensors or physical sensors for detecting volume changes of battery cells have been chiefly used to detect gas in batteries.

Because these methods basically rely on the release of gas to atmosphere or external changes, they fail to detect internal gas without any physical change, and they correspond to a post-event detection method, so they may not be optimum for preliminary or precautionary action or measures or management.

On the other hand, there are some disclosed methods for diagnosing gas generation using the electrical properties of batteries such as Ohmic resistance, resistance change ratio or capacity change ratio, but these methods need intricate processing such as complex number-based impedance calculation to use Electrochemical Impedance Spectroscopy (EIS).

### CONTENT OF THE INVENTION

### Technical Problem

The present disclosure is designed to solve the above-described problem under the above-described background, and therefore the present disclosure is directed to providing a battery management apparatus and method for diagnosing the gas generation state of a battery cell quickly and reliably by using a differential profile of the battery cell acquired and generated through a straightforward method.

The technical problem to be solved by the present disclosure is not limited to the above-described problems and these and other problems will be clearly understood by those skilled in the art from the following description.

### Technical Solution

A battery management apparatus according to an aspect of the present disclosure includes a setting control unit configured to set a reference voltage that is a reference of determination of a risk caused by a rapid increase of gas, a measurement unit configured to measure a voltage of a battery cell, and a diagnosis unit configured to diagnose the battery cell as a dangerous cell in which a degree of risk caused by the rapid increase of gas is equal to or higher than a predetermined level when the voltage of the battery cell higher than the reference voltage lasts for a first reference time or more.

The setting control unit may include a data processing unit configured to generate a differential profile indicating a correspondence relationship between the voltage of the battery cell and a differential capacity using a battery profile indicating a correspondence relationship between the voltage and a capacity of the battery cell, a characteristic point selection unit configured to select a characteristic point at which the differential capacity is maximum in a high voltage range from the differential profile, and a reference setting unit configured to set the reference voltage based on a voltage of the characteristic point.

The diagnosis unit may be configured to differently apply the first reference time depending on a magnitude of the voltage of the battery cell. The diagnosis unit may be configured to apply a shorter time as the first reference time as a voltage difference between the voltage of the battery cell and the reference voltage increases.

The characteristic point selection unit may be configured to select the characteristic point using the updated differential profile when the differential profile is updated. The reference setting unit may be configured to update the reference voltage using the voltage of the characteristic point.

The battery management apparatus may further include a management control unit configured to control to perform a discharging process on the battery cell when the battery cell is diagnosed as the dangerous cell in which the degree of risk caused by the rapid increase of gas is equal to or higher than the predetermined level.

The battery management apparatus may further include a temperature sensor configured to measure a temperature of the battery cell. The diagnosis unit may be configured to diagnose the battery cell as the dangerous cell in which the degree of risk caused by the rapid increase of gas is equal to or higher than the predetermined level when a state in which the temperature of the battery cell is higher than a reference temperature lasts for a second reference time or more.

The diagnosis unit may be configured to differently apply the second reference time depending on a magnitude of the temperature of the battery cell. The diagnosis unit may be configured to apply a shorter time as the second reference time as a temperature difference between the temperature of the battery cell and the reference temperature increases.

A battery pack according to another aspect of the present disclosure includes the battery management apparatus.

An electric vehicle according to another aspect of the present disclosure includes the battery pack.

A battery management method according to another aspect of the present disclosure includes setting a reference voltage that is a reference of determination of a risk caused by a rapid increase of gas, measuring a voltage of a battery cell, and diagnosing the battery cell as a dangerous cell in which a degree of risk caused by the rapid increase of gas is equal to or higher than a predetermined level when a state in which the voltage of the battery cell is higher than the reference voltage lasts for a first reference time or more.

The step of setting the reference voltage may include generating a differential profile indicating a correspondence relationship between the voltage of the battery cell and a differential capacity using a battery profile indicating a correspondence relationship between the voltage and a capacity of the battery cell, selecting a characteristic point at which the differential capacity is maximum a high voltage range from the differential profile, and setting the reference voltage based on a voltage of the characteristic point.

### Effects of the Invention

According to an embodiment of the present disclosure, it may be possible to effectively diagnose gas generation of the battery cell by a more straightforward method because characteristics changes by gas generation may be applied to a data analysis process in a systematic manner.

Additionally, according to an embodiment of the present disclosure, it may be possible to diagnose the current state of the battery cell such as internal gas generation more easily and quickly by the process of analyzing the differential profile representing the characteristics of the battery cell and making use of the same, and reflect the current state of the battery cell that dynamically changes more substantially by using the differential profile updated in time series.

Additionally, according to an embodiment of the present disclosure, it may be possible to ensure safety of the battery cell more effectively by differently applying the reference time, one of parameters of determining the dangerous level of gas generation, depending on voltage of the battery cell or/and temperature of the battery cell.

Further, the process by the present disclosure may be implemented through software processing that can be mounted in battery management systems (BMS) commonly used in battery devices or systems, thereby providing higher scalability.

### BRIEF DESCRIPTION OF THE DRAWINGS

The accompanying drawings illustrate the exemplary embodiments of the present disclosure and together with the following detailed description, serve to provide a more effective understanding of the technical aspect of the present disclosure, and thus the present disclosure should not be construed as being limited to the drawings.
FIG. 1 is a detailed block diagram of a battery management apparatus according to an embodiment of the present disclosure.
FIG. 2 is a detailed block diagram of a setting control unit shown in FIG. 1.
FIG. 3 is a flowchart illustrating a process of diagnosing the state of a battery cell according to an embodiment of the present disclosure.
FIG. 4 is a flowchart illustrating an example of a process for setting a reference voltage that is the reference of determination of risk caused by rapid increase of gas according to an embodiment of the present disclosure.
FIG. 5 a flowchart illustrating a diagnosis process of a battery cell according to another embodiment of the present disclosure.
FIG. 6 is a diagram showing an example of a differential profile of a battery cell.
FIG. 7 is an up-scaled diagram of a high voltage area shown in FIG. 6.
FIG. 8 is a diagram showing an example of a gas increase ratio as a function of temperature and voltage of a battery cell.
FIG. 9 is a diagram referenced in describing a process of differently determining a reference time according to an embodiment of the present disclosure.

### BEST MODE

Hereinafter, the exemplary embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspect of the present disclosure and are not intended to be limiting, so it should be understood that a variety of other equivalents and modifications could have been made thereto at the time the application was filed.

Additionally, in describing the present disclosure, when it is determined that a certain detailed description of related known elements or functions may make the subject matter of the present disclosure obscure or unclear, the detailed description is omitted.

Unless the context clearly indicates otherwise, the terms "comprise" and "include" when used in this specification, specify the presence of stated elements, but do not preclude the presence or addition of one or more other elements.

Additionally, the term "processor" as used herein refers to a processing unit of at least one function or operation, and may be implemented by hardware or software or a combination thereof.

In addition, throughout the specification, it will be further understood that when an element is referred to as being "connected to" another element, it can be directly connected to the other element or intervening elements may be present.

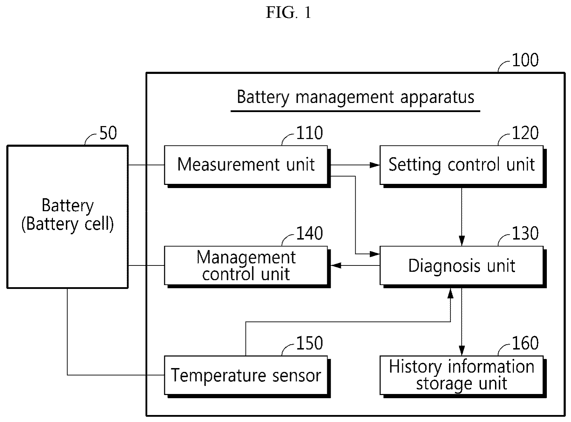

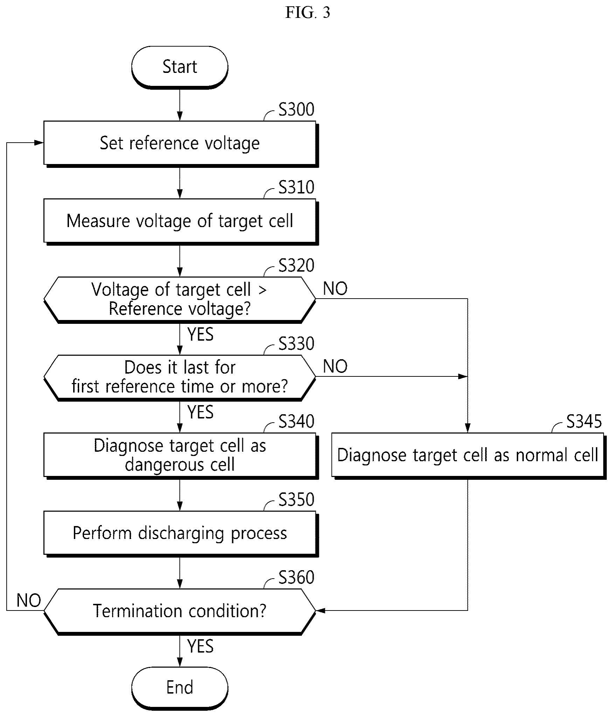

FIG. 1 is a detailed block diagram of a battery management apparatus according to an embodiment of the present disclosure, and FIG. 3 is a flowchart illustrating a process of diagnosing the state of a battery cell according to an embodiment of the present disclosure.

First, components of the battery management apparatus 100 by the present disclosure and processes performed by the components will be described in detail with reference to FIG. 1 and the related drawings.

As shown in FIG. 1, the battery management apparatus 100 of the present disclosure may include a measurement unit 110, a setting control unit 120, a diagnosis unit 130, a management control unit 140, a temperature sensor 150 and a history information storage unit 160.

Prior to the detailed description of the present disclosure, it should be noted that the battery management apparatus 100 may be realized through a variety of combinational applications of electronic elements or components such as storage means, computation processing means, or input/output means (ASIC, a chipset, a logic circuit, a register, a communication modem, MCU, etc.).

Therefore, each component of the battery management apparatus 100 shown in FIG. 1 should be understood as components that are distinguished functionally or logically rather than physically. The same is the case with each component of the setting control unit 120 shown in FIG. 3.

That is, each component shown in the drawings corresponds to a logical component for effectively describing the technical aspect of the present disclosure, so it should be interpreted that each component falls in the range of the present disclosure when the function performed by the logical component of the present disclosure can be accomplished even though each component is combined or separated, and it should be also interpreted that the components performing identical or similar functions fall in the range of the present disclosure regardless of whether the names are identical.

Additionally, the battery diagnosis method or battery management method according to the present disclosure may be entirely realized as a set of processes or algorithms related to data processing, manipulation, control, computation or input/output, and may be realized as a combination of logical components shown in FIG. 1 as well as software that runs on a system, a device, a computer (or its similar device), a BMS, a module or its subordinate components.

The battery management apparatus 100 may be configured to diagnose the current state of a battery cell 50 such as gas generation (rapid increase of gas), and according to an embodiment, may be configured to generate and output diagnosis data of the battery cell 50 for systematic connection with other component or module/device. Hereinafter, the battery cell 50 whose state to be diagnosed may be referred to as a 'target cell'.

A plurality of target cells 50 diagnosed and managed by the battery management apparatus 100 may be included in an upper level of assembly such as a cell assembly, a battery module or a battery pack through an electrical connection method in series, in parallel or a combination thereof.

The setting control unit 120 sets a reference voltage that is the reference of gas generation or rapid increase of gas (S300, see FIG. 3).

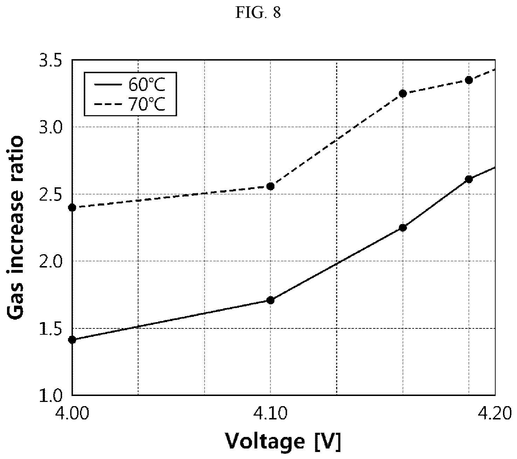

FIG. 8 is a diagram showing a graphical representation of data indicating the tendency of a gas increase ratio, which is a ratio of an amount of gas generated when a new cell (i.e., a battery cell at BOL) is placed untouched under a voltage in a high voltage area HV at two or more non-standard temperatures (for example, 60°C and 70°C) for a predetermined time to an amount of gas generated when the new cell is placed untouched under a standard voltage (for example, 3.90V) at the standard temperature (for example, room temperature) for the predetermined time.

The amount of gas generated (or gas generation speed) in the target cell 50 has a close relationship with the voltage environment or/and temperature environment of the target cell 50. As can be seen from FIG. 8, as the temperature is higher and the voltage is higher, the amount of gas generated for the same time increases. In other words, in the same temperature condition, the amount of gas generated increases with increasing voltage of the target cell 50, and in the same voltage condition, the amount of gas generated increases with increasing temperature of the target cell 50.

Accordingly, based on the results of multiple pre-tests done on a battery cell having substantially the same specification as the target cell 50, the reference voltage or voltage at which gas is generated at a dangerous level may be preset. As an example, both change ratios of two curves for 60°C and 70°C shown in FIG. 8 greatly increase at or near 4.10V. The inventors found that when the degree of degradation (for example, SOH) of the target cell 50 is known, the change ratio of the gas increase ratio curve greatly change more than a predetermined reference value in a predetermined size of voltage range on the basis of voltage of a characteristic point of a differential profile of the target cell 50. For example, assuming that the target cell 50 is at BOL, 4.10V may be set as the reference voltage.

The reference voltage is preferably set, further reflecting the safety level of the application device on which the target cell 50 is mounted, the degree of aging, capacity characteristics, SOH of the target cell 50 and so on. The particular embodiment of the present disclosure of setting the reference voltage will be described below.

The measurement unit 110 is electrically connected to the target cell 50 to measure a voltage (referred to as 'cell voltage' or "terminal voltage') across the target cell 50 (S310) and output the measured voltage. The measurement unit 110 may include a variety of known means for measuring an electrical characteristic value (voltage, current, etc.) of the target cell 50, and a variety of electrical connection methods may be applied according to the type of the electrical characteristic value.

When the current voltage of the target cell 50 is lower than the reference voltage (S320), the diagnosis unit 130 identifies a stable state in which the degree of risk of gas generation does not exceed the threshold and diagnoses the corresponding target cell 50 as a normal cell (S345).

Additionally, as a result of performing the procedure (S320) of comparing the current voltage of the target cell 50 with the reference voltage, when the current voltage of the target cell 50 is higher than the reference voltage (hereinafter referred to as 'first event'), but the first event does not last for a first reference time or more (the value of S330 is 'NO'), the diagnosis unit 130 may diagnose the corresponding target cell 50 as a normal cell (S345).

Through this exemplary configuration, the present disclosure may effectively filter signal processing errors when the voltage of the target cell 50 is temporarily high or due to the presence of noise components.

The first reference time may be preset, taking into account the characteristics of the target cell 50 itself or various parameters of the application device to which the target cell 50 is applied in the same way as the above-described reference voltage.

As opposed to this, when the first event, i.e., the state in which the current voltage of the target cell 50 is higher than the reference voltage lasts for the first reference time or more (the value of S330 is 'YES'), the diagnosis unit 130 diagnoses the corresponding target cell 50 as a dangerous cell in which the degree of risk caused by the rapid increase of gas is a predetermined level or more (S340).

When the specific target cell 50 is diagnosed as the dangerous cell, the diagnosis unit 130 may generate diagnosis data and/or history information in which identification information of the specific target cell 50, time information of designation as the dangerous cell, the reference voltage at the corresponding time, and voltage information of the target cell 50 is connected to each other and store it in the history information storage unit 160.

According to an embodiment, the history information may be used for systematic connection with other component or module/device, and may be used in the process of determining the degradation time of the target cell 50 or identifying characteristics changes of the target cell 50 in time series.

When the diagnosis unit 130 diagnoses the specific target cell 50 as the dangerous cell, the management control unit 140 may perform control to limit the charge/discharge (capacity range, use time range, maximum and minimum voltage range, etc.) of the corresponding target cell 50. Additionally, when the target cell 50 is diagnosed as the dangerous cell, the management control unit 140 may perform control to perform a discharging process on the target cell 50 (S350). The discharging process may be performed through a method that applies discharge pulses or electrically connects discharge loads across the target cell 50.

In response to the degree of safety risk determined to be high by the gas generation or rapid increase of gas in the target cell 50, the present disclosure may discharge the target cell 50 to take a precautionary action or measures more effectively before a critical safety problem occurs.

The above-described process of the present disclosure may be iteratively applied unless a preset termination condition such as forced termination, system-down or emergent event generation is met (the value of S360 is 'NO').

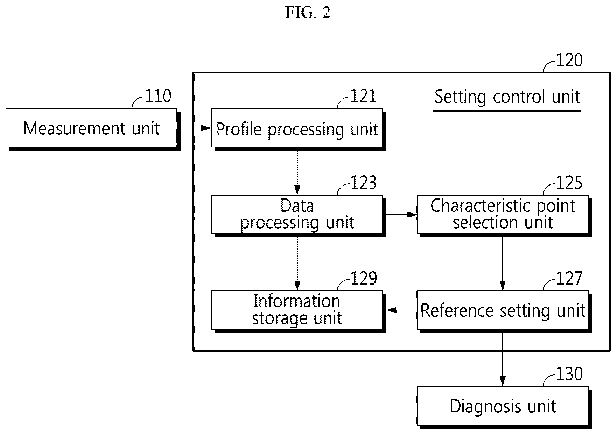

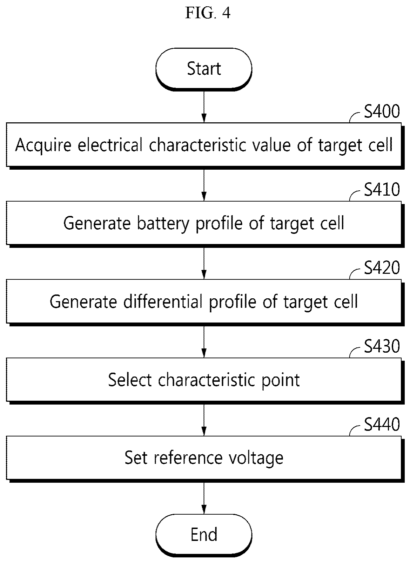

FIG. 2 is a detailed block diagram of the setting control unit 120 shown in FIG. 1, and FIG. 4 is a flowchart illustrating an example of the process of setting the reference voltage that is the reference of determination of risk caused by the rapid increase of gas. Hereinafter, the embodiment of the present disclosure of setting the reference voltage will be described in detail with reference to the drawings.

The setting control unit 120 corresponds to the component that sets the above-described reference voltage, sufficiently reflecting the characteristics of the target cell 50, to improve the precision of dangerous cell determination and consequential management and control processes.

Referring to FIG. 2, the setting control unit 120 may include a profile processing unit 121, a data processing unit 123, a characteristic point selection unit 125, a reference setting unit 127 and an information storage unit 129. Each component shown in FIG. 2 may correspond to logical components as noted above.

The profile processing unit 121 is configured to acquire a battery profile (a charge/discharge profile) of the target cell 50. Here, the battery profile refers to a profile indicating a correspondence relationship of voltage (Voltage) and capacity (or SOC) of the target cell 50.

The battery profile may be stored in the profile processing unit 121 of the present disclosure for future use, by receiving inputs from a separate device or module.

Additionally, according to an embodiment, as shown in FIG. 1, through the measurement unit 110 electrically connected to the target cell 50, the electrical characteristic value of the target cell 50 may be acquired and recorded (S400), and the battery profile of the target cell 50 may be generated based on time series of the recorded electrical characteristic value (S410).

The SOC indicates a ratio of current capacity to maximum capacity and is represented as 0 to 1 or 0% to 100%, and may be generated by various techniques and technologies such as current accumulation, equivalent circuit model or Kalman filter and according to an embodiment, information about SOC may be generated, further reflecting temperature information.

Because the battery profile represents the correspondence relationship of voltage and capacity (or SOC) of the target cell 50, according to an embodiment, the battery profile may be a dataset in which the voltage value and the capacity value measured at the same time are mapped to each other.

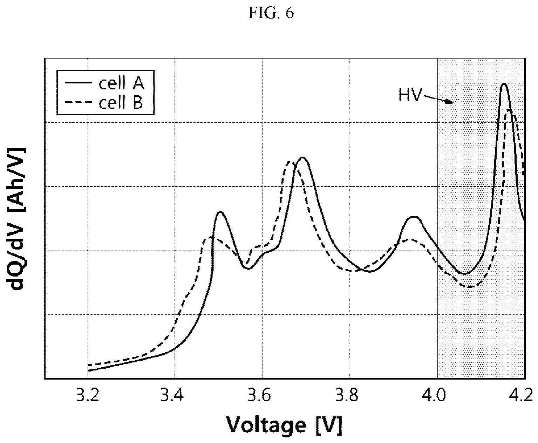

The data processing unit 123 performs function processing for the battery profile to generate the differential profile indicating the correspondence relationship between voltage of the target cell 50 and differential capacity for the corresponding voltage (S420). FIG. 6 shows the differential profile of each of two battery cells (cell A and cell B) having different States of Health (SOH). The battery cell (cell A) may be a new cell having SOH of 100%, and the battery cell (cell B) may be a degraded cell having SOH of less than 100%.

According to an embodiment, the data processing unit 123 may be configured to acquire a differential profile (hereinafter referred to as 'reference profile') indicating a correspondence relationship between voltage of the new battery cell at BOL corresponding to the specification or type of the target cell 50 and its differential capacity.

The differential capacity is obtained by differentiating capacity vs voltage, and may be expressed as "dQ/dV", and its unit may be [Ah/V]. When the battery profile on which the differential profile is based is a profile generated during charging, with X axis of the 2-dimensional coordinates set as voltage and Y axis set as differential capacity, the differential profile (the differential capacity profile) may be represented in the form of a 2-dimensional graph as shown in FIG. 6.

When function processing such as symmetric transformation or variable conversion is applied, the technical aspect of the present disclosure may be also applied when the differential profile is generated based on the battery profile generated during discharging.

When gas is generated in the target cell 50, the intrinsic characteristics may be primarily exhibited in the high voltage area of the target cell 50. Thus, to sufficiently reflect these characteristics, it may be preferable to use data (a part of the differential profile) corresponding to the high voltage area HV (see FIG. 6) that is equal to or higher than a predetermined voltage of interest (for example 4.00V) in the differential profile.

To this end, the characteristic point selection unit 125 may select (determine) a characteristic point representing the differential voltage-the amount of gas generated of the corresponding target cell 50 using the data (the differential profile) corresponding to the high voltage area HV in the differential profile (S430).

Specifically, the characteristic point may be a maximum point at which the differential capacity is maximum in the voltage area that is equal to or larger than the voltage of interest, i.e., an inflection point at which the function value (the differential capacity) is maximum.

The inflection point may refer to a point at which a tendency of a slope changes on the basis of the graph or curve shape of the battery profile, i.e., a point at which the symbol of a slope increase ratio changes (from positive to negative or vice versa). For example, in the graph of the battery profile, the inflection point refers to a point at which an uneven or curved shape change, i.e., a convex (upward convex) and concave (downward convex) shape change is generated.

The inflection point is a point at which a change originating from the intrinsic characteristics of the target cell 50 occurs, and may act as an important parameter point indicating intrinsic state or characteristics of the target cell 50.

The voltage of interest is a voltage as the reference for distinguishing the high voltage area HV from the entire available voltage area, and may be variably set depending on the specification or type of the target cell 50. For example, on the basis of the battery cell of which the upper voltage limit is designed as 4.2V, the voltage of interest may be set to 4.0V that is lower than the upper voltage limit.

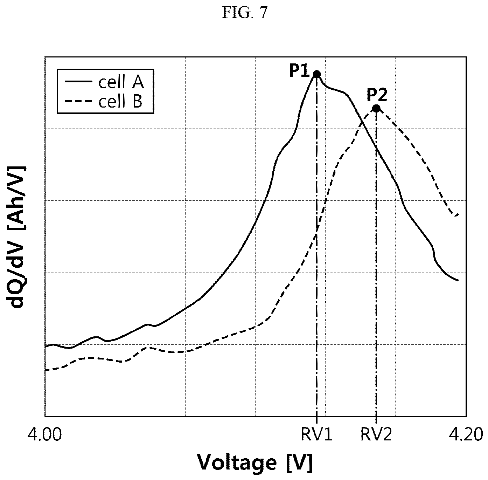

On the basis of the two differential profiles shown in FIG. 6, the two characteristic points P1, P2 respectively for the two the battery cells (cell A, cell B) are shown in FIG. 7. For reference, FIG. 7 is a scale-up diagram of the high voltage area HV in the differential profile shown in FIG. 6 on the basis of the voltage variable.

When the characteristic point of the target cell 50 is selected, the reference setting unit 127 may set the reference voltage on the basis of the voltage (hereinafter referred to as 'first voltage') of the characteristic point (S440).

On the basis of the embodiment shown in FIG. 7, in the case where the target cell 50 is the battery cell (cell A), RV1 is the first voltage, and in the case where the target cell 50 is the battery cell (cell B), RV2 is the first voltage.

The reference voltage may be set to substantially the same value as the voltage of the characteristic point, but may be set to a lower or higher value than the voltage of the characteristic point by the addition or subtraction of a predetermined weight for safety, and according to an embodiment, may be set within a predetermined range.

The target cell 50 cannot maintain the performance at BOL and is gradually degraded or ages as the charge/discharge cycles last or repeat. By the change of behavioral characteristics, the first voltage or the voltage of the characteristic point at which the differential capacity is maximum in the high voltage area of the differential profile may change over time.

Accordingly, compared to maintaining the fixed reference voltage determined through the initial setting process, varying reference voltages over time may preferably reflect the current state of the target cell 50 more accurately.

To this end, the data processing unit 123 updates (generates) the above-described differential profile periodically. When the differential profile is updated, the characteristic point selection unit 125 may be configured to select the characteristic point using the differential profile generated latest on the basis of the current time.

Additionally, through this process, when the characteristic point is updated in time series, the reference setting unit 127 may be configured to update the reference voltage using the first voltage that changes by the updates of the characteristic point.

As described above, to effectively filter unnecessary processes, when the first event (the state in which the current voltage of the target cell is higher than the reference voltage) lasts for the first reference time or more, the present disclosure is configured to diagnose the corresponding target cell 50 as the dangerous cell, and perform the discharging process.

In relation to this, when the current voltage of the target cell 50 is higher than the reference voltage, it may be possible to ensure safety of the target cell 50 more effectively by differently applying the first reference time depending on the magnitude of the current voltage, rather than applying the first reference time of the same length irrespective of the current voltage of the target cell 50.

As described with reference to FIG. 8, the amount of gas generated (or gas generation speed) tends to increase with increasing voltage of the target cell 50. Thus, to reflect the behavioral characteristics on the battery control more effectively, the diagnosis unit 130 may adjust the first reference time according to the magnitude of the current voltage of the target cell 50. The diagnosis unit 130 may be configured to determine a shorter time as the first reference time as a difference value between the current voltage of the target cell 50 and the reference voltage increases. That is, the diagnosis unit 130 may determine the first reference time based on relationship data defining a predetermined positive correspondence relationship between the voltage difference between the current voltage of the target cell 50 and the reference voltage and the first reference time.

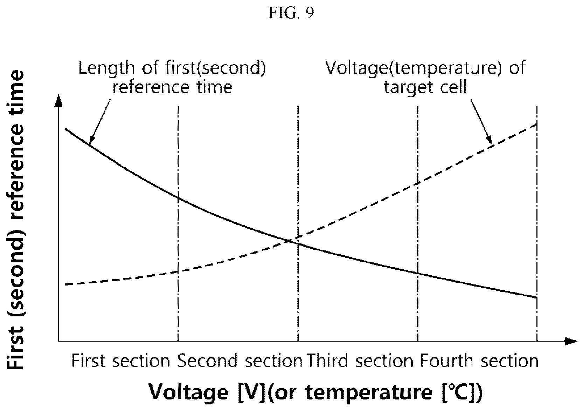

FIG. 9 is a diagram referenced in describing the process of differently determining the reference time according to an embodiment of the present disclosure.

Referring to the example shown in FIG. 9, as the voltage of the target cell 50 is higher, i.e., as the voltage difference between the current voltage of the target cell 50 and the reference voltage increases, the first reference time used for diagnosis of the risk caused by the rapid increase of gas may be shorter. From the corresponding perspective, as the voltage difference between the current voltage of the target cell 50 and the reference voltage decreases, the first reference time used for diagnosis of the risk caused by the rapid increase of gas may be longer.

As shown in FIG. 9, according to an embodiment, a plurality of sections (first to fourth sections) for voltage and/or temperature may be predefined, and the first reference time having different length may be applied according to the section to which the current voltage of the target cell 50 belongs.

That is, when the current voltage of the target cell 50 is much higher than the reference voltage, a shorter time may be applied to the first reference time, and on the contrary, when the current voltage of the target cell 50 is higher than the reference voltage, but their voltage difference is not too large, a longer time may be applied as the first reference time. Accordingly, it may be possible to increase efficiency of risk diagnosis and the control process, and improve safety of the target cell 50 or an assembly or module of the target cells 50 while in operation.

The information about the reference voltage set by the reference setting unit 127 may be stored in the information storage unit 129 together with the differential profile for the purpose of use in the subsequent process or application process.

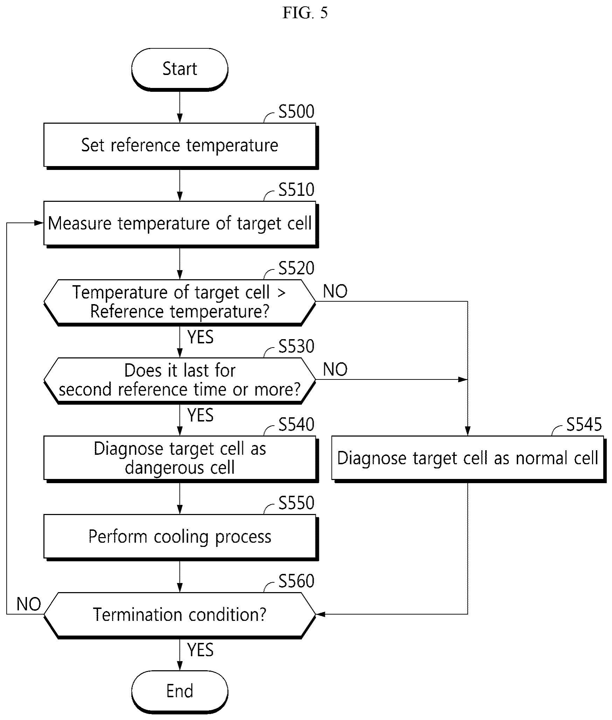

FIG. 5 a flowchart illustrating the diagnosis process of the battery cell according to another embodiment of the present disclosure.

As described above with reference to FIG. 8, because gas in the target cell 50 tends to increase as the temperature increases, it is preferable to perform different control according to the temperature environment of the target cell 50.

To this end, the setting control unit 120 sets a reference temperature that is the reference of gas generation or rapid increase of gas (S500).

As described above, based on the results of multiple pre-tests done on a battery cell having substantially the same specification as the target cell 50, the reference temperature or temperature at which gas is generated at a dangerous level may be preset.

Like the above-described reference voltage, the reference temperature is preferably set, further reflecting the safety level of the application device on which the target cell 50 is mounted, the degree of aging, capacity characteristics or SOH of the target cell 50, the temperature environment of the module or device on which the target cell 50 is mounted and so on.

The temperature sensor 150 measures the current temperature of the target cell 50 (S510), and outputs the measured temperature information to the diagnosis unit 130.

When the current temperature of the target cell 50 is lower than the reference temperature (the value of S520 is 'NO'), the diagnosis unit 130 identifies that the degree of risk of gas generation is not too high and diagnoses the corresponding target cell 50 as a normal cell (S545).

Additionally, when the current temperature of the target cell 50 higher than the reference temperature (hereinafter referred to as 'second event') is determined in the step S520, but the second event does not last for a second reference time or more (the value of S530 is 'NO'), the diagnosis unit 130 may diagnose the corresponding target cell 50 as a normal cell (S545).

Through this exemplary configuration, the present disclosure may effectively filter the risk not lasting, for example, the temperature of the target cell 50 is temporarily high.

The second reference time may be set, taking into account the characteristics of the target cell 50 itself, or various parameters of the application device to which the target cell 50 is applied in the same way as the first reference time or the reference temperature described above.

As opposed to this, in the case of the second event, i.e., the state in which the current temperature of the target cell 50 is higher than the reference temperature lasts for the second reference time or more (the value of S530 is 'YES'), the diagnosis unit 130 diagnoses the target cell 50 as the dangerous cell in which the degree of risk caused by the rapid increase of gas is equal to or higher than the predetermined level (S540).

When the specific target cell 50 is diagnosed as the dangerous cell, the diagnosis unit 130 may generate diagnosis data or history information in which identification information of the specific target cell 50, time information of designation as the dangerous cell, and reference voltage information at the corresponding time are connected to each other, and store it in the history information storage unit 160.

When the specific target cell 50 is diagnosed as the dangerous cell by the diagnosis unit 130, the management control unit 140 may perform control to limit the charge/discharge of the dangerous cell (capacity range, use time range, maximum and minimum voltage range, etc.). The management control unit 140 may perform a cooling process on the corresponding dangerous cell through operation of a cooling fan, circulation of cooling water, or operation of a cooling device (S550).

As described with reference to FIG. 8, as the temperature of the target cell 50 increases, the amount of gas generated (or gas generation speed) tends to increase. To reflect the behavioral characteristics on the battery control more effectively, the diagnosis unit 130 may differently apply the second reference time depending on the magnitude of the current temperature of the target cell 50. Specifically, when the current temperature of the target cell 50 is higher than the reference temperature, the diagnosis unit 130 may be configured to use a shorter time as the second reference time as a temperature difference between the current temperature of the target cell 50 and the reference temperature increases.

As shown in FIG. 9, as the temperature of the target cell 50 is higher, i.e., as the difference between the current temperature of the target cell 50 and the reference temperature increases, the diagnosis unit 130 may reduce the second reference time. From the corresponding perspective, as the difference between the current temperature of the target cell 50 and the reference temperature decreases, the diagnosis unit 130 may increase the second reference time.

As shown in FIG. 9, according to an embodiment, the plurality of sections (first to fourth sections) may be set, and the second reference time having different length may be applied according to the section to which the current temperature of the target cell 50 belongs.

The above-described embodiment, i.e., the embodiment of diagnosing the target cell 50 using the temperature information of the target cell 50 and the reference temperature and performing the subsequent process may be applied independently of the above-described embodiment of diagnosing the target cell 50 using the current voltage of the target cell 50 and the reference voltage, and according to an embodiment, they may be applied together.

The battery management apparatus 100 may be applied to a Battery Management System (BMS). That is, the BMS according to the present disclosure may include the above-described battery management apparatus 100. In this configuration, at least some of the components of the battery management apparatus 100 may be implemented by complementing or adding the functions of the components included in the conventional BMS.

Additionally, the battery management apparatus 100 may be equipped in a battery pack. That is, the battery pack according to the present disclosure may include the above-described battery management apparatus 100 and at least one battery cell, a battery assembly, a battery module or a battery cell group.

Further, the battery management apparatus 100 may be equipped in an electric vehicle such as a hybrid electric vehicle. That is, the electric vehicle according to the present disclosure may include the battery management apparatus 100 or the battery pack according to the present disclosure. Additionally, in addition to the battery management apparatus or the battery pack, the electric vehicle according to the present disclosure may further include any other component included in the electric vehicle. For example, in addition to the device according to the present disclosure, the electric vehicle according to the present disclosure may further include a vehicle body, a motor, or a controller such as an electronic control unit (ECU).

Although the present disclosure has been hereinabove described with regard to a limited number of embodiments and drawings, the present disclosure is not limited thereto and a variety of modifications and changes may be made by those skilled in the art within the technical aspect of the present disclosure and the scope of the appended claims and their equivalents.

The accompanying drawings for the description of the present disclosure and illustration of the embodiments of the present disclosure may be shown in an exaggerated form for emphasis of the technical aspect of the present disclosure, but it should be interpreted that it is obvious that various modifications and changes may be made at the level of ordinary skilled in the art having regard to the foregoing description and the illustration in the drawings.

Additionally, the terms first, second, upper, lower and top-bottom as used herein are terms of the concept of tools used to distinguish each component (element) from each other, and they are not terms used to indicate a specific sequence or order of priority, or physically distinguish each component (element) according to the absolute standard.

## Claims

1. A battery management apparatus comprising:
a setting control unit configured to set a reference voltage that is a reference of determination of a risk caused by a rapid increase of gas;
a measurement unit configured to measure a voltage of a battery cell; and
a diagnosis unit configured to diagnose the battery cell as a dangerous cell in which a degree of risk caused by the rapid increase of gas is equal to or higher than a predetermined level when the voltage of the battery cell higher than the reference voltage lasts for a first reference time or more.

2. The battery management apparatus according to claim 1,
wherein the setting control unit comprises:
a data processing unit configured to generate a differential profile indicating a correspondence relationship between the voltage of the battery cell and a differential capacity using a battery profile indicating a correspondence relationship between the voltage and a capacity of the battery cell;
a characteristic point selection unit configured to select a characteristic point at which the differential capacity is maximum from the differential profile; and
a reference setting unit configured to set the reference voltage based on a voltage of the characteristic point.

3. The battery management apparatus according to claim 1,
wherein the diagnosis unit is configured to:
differently apply the first reference time depending on a magnitude of the voltage of the battery cell,
wherein as a voltage difference between the voltage of the battery cell and the reference voltage increases, a shorter time is applied as the first reference time.

4. The battery management apparatus according to claim 2,
wherein the characteristic point selection unit selects the characteristic point using the updated differential profile when the differential profile is updated, and
wherein the reference setting unit updates the reference voltage using the voltage of the characteristic point.

5. The battery management apparatus according to claim 1, further comprising:
a management control unit configured to control to perform a discharging process on the battery cell when the battery cell is diagnosed as the dangerous cell in which the degree of risk caused by the rapid increase of gas is equal to or higher than the predetermined level.

6. The battery management apparatus according to claim 1, further comprising:
a temperature sensor configured to measure a temperature of the battery cell,
wherein the diagnosis unit is further configured to:
diagnose the battery cell as the dangerous cell in which the degree of risk caused by the rapid increase of gas is equal to or higher than the predetermined level when a state in which the temperature of the battery cell is higher than a reference temperature lasts for a second reference time or more.

7. The battery management apparatus according to claim 6,
wherein the diagnosis unit is configured to:
differently apply the second reference time depending on a magnitude of the temperature of the battery cell,
wherein a shorter time is applied as the second reference time as a temperature difference between the temperature of the battery cell and the reference temperature increases.

8. A battery pack comprising the battery management apparatus according to any one of claims 1 to 7.

9. An electric vehicle comprising the battery pack according to claim 8.

10. A battery management method comprising:
setting a reference voltage that is a reference of determination of a risk caused by a rapid increase of gas;
measuring a voltage of a battery cell; and
diagnosing the battery cell as a dangerous cell in which a degree of risk caused by the rapid increase of gas is equal to or higher than a predetermined level when a state in which the voltage of the battery cell is higher than the reference voltage lasts for a first reference time or more.

11. The battery management method according to claim 10,
wherein setting the reference voltage further comprises:
generating a differential profile indicating a correspondence relationship between the voltage of the battery cell and a differential capacity using a battery profile indicating a correspondence relationship between the voltage and a capacity of the battery cell;
selecting a characteristic point at which the differential capacity is maximum from the differential profile; and
setting the reference voltage based on a voltage of the characteristic point.
